# EUROPEAN PATENT APPLICATION

(11) **EP 4 539 614 A1**
(43) Date of publication of application: **16.04.2025**
(21) Application number: 23879498.6
(22) Date of filing: 05.09.2023
(51) Int. Cl.: H05K 1/14, H05K 3/34

(54) **SPACER FOR CIRCUIT BOARD**

(30) Priority: 17.10.2022 JP 2022165949
(71) Applicant: Rhythm Co., Ltd., Saitama-shi, Saitama 330-9551 (JP)
(72) Inventor: SEKI, Toshihiro, Saitama-shi, Saitama 330-9551 (JP); KITAJIMA, Yoshikazu, Saitama-shi, Saitama 330-9551 (JP)
(74) Representative: terpatent PartGmbB
(86) International application number: PCT/JP2023/032379
(87) International publication number: WO 2024/084847

(57) **Abstract**

......A circular conductor pattern (5) corresponding to a lower end surface (1b) of a cylindrical spacer (1) is formed on a circuit board (4), a resist (6) is formed around the conductor pattern (5), and the spacer (1) is mounted in a posture in which the lower end surface (1b) is in contact with the conductor pattern (5). The conductor pattern (5) has its center in which a circular resist (16) is formed so as to protrude upward. A cylindrical fitting portion (15b) is formed on the lower end surface (1b) of the spacer (1) and is fitted to the circular resist (16) to position the spacer (1). In addition, a diameter-reduced portion (14b) is formed around the lower end surface (1b) to expose the conductor pattern (5) upward, and when the spacer (1) is mounted, molten solder is caused to stick to an outer circumferential surface of the diameter-reduced portion (14b) on the conductor pattern (5) by surface tension, thereby forming a fillet (19).

## Description

### Technical Field

The present invention relates to a spacer for use in a circuit board.

### Background Art

For example, as described in Patent Document 1, this type of spacer is used to fasten an object to be fastened, such as another circuit board, a bus bar, or a round terminal, at an interval on a circuit board. The spacer is mounted on the circuit board in advance, and the object to be fastened is fastened by a screw to a female screw formed in the spacer.

The following describes the mounting structure of a conventional spacer for a circuit board as described in Patent Document 1. For example, in a prior art 1 shown in FIG. 6, a female screw 102 is provided so as to penetrate a spacer 101 along an axis C of the spacer 101. The female screw 102 has a lower end surface 101b formed in an annular shape surrounding an opening portion of the female screw 102. The area on the circuit board 104 corresponding to the lower end surface 101b of the spacer 101 is formed with a conductor pattern 105, around which a resist 106 is formed. For example, in the mounting work of the spacer 101 by reflow soldering, a solder paste 117 is printed on the conductor pattern 105, and the spacer 101 is placed at a desired position on the circuit board 104 by a chip mounter and undergoes a heating process in a furnace, so that the spacer is mounted.

However, the mounting structure of the spacer 101 of the prior art 1 has a problem that the spacer 101 is only joined to the conductor pattern 105 via the planar solder layer 118 corresponding to the lower end surface 101b, and the joining strength to the circuit board 104 is therefore low.

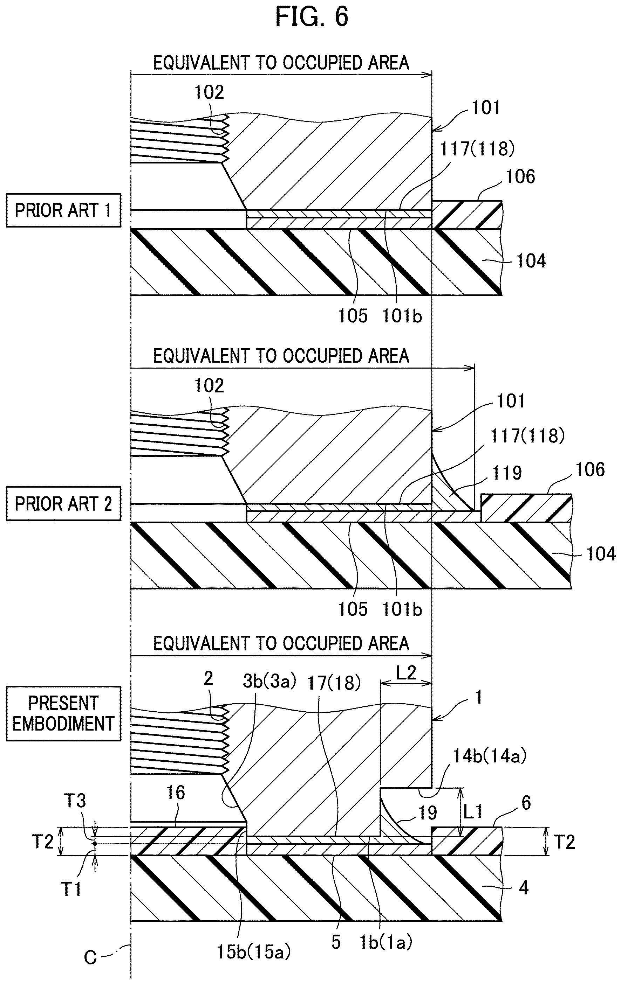

For a countermeasure, a mounting structure is also employed in which the conductor pattern 105 is expanded to the outer circumference side and exposed upward, as shown in a prior art 2 in FIG. 6. In this case, the solder molten in a heating process sticks to the outer circumferential surface of the spacer 101 due to surface tension, and solidifies. Thereby, a fillet 119 is formed that has a roughly triangular cross section on the outer circumference of the lower end portion of the spacer 101. As a result, the entire circumference of the lower end portion of the spacer 101 is restrained on the conductor pattern 105 via the fillet 119. This greatly improves the joining strength to the circuit board 104.

### Prior Art Document

### Patent Document

Patent Document 1: Japanese Patent Laid-Open No. 2020-122488

### Summary of the Invention

### Problems to be solved by the Invention

However, the mounting structure of the spacer 101 of the prior art 2 has a problem that the area occupied by the spacer 101 on the circuit board 104 is increased.

In other words, in the case of the prior art 1, the spacer 101 occupies the area on the circuit board 104 corresponding to the outer shape of the spacer 101, which is circular in a plan view, whereas in the case of prior art 2, the spacer 101 additionally has an occupied area of the annular fillet 119 surrounding the circumference of the spacer 101. Such an increase in the occupied area of the spacer 101 affects the arrangement of surrounding electronic components, and may be a cause of imposing a restriction on the board design at last.

The present invention has been made to solve these problems, and an object of the present invention is to provide a spacer for a circuit board that can be mounted on a circuit board with high joining strength while preventing increase in an area occupied by the spacer on the circuit board.

### Means for Solving the Problems

To achieve the above object, a spacer for a circuit board of the present invention is a spacer for a circuit board to be applied to a mounting structure of a circuit board, the mounting structure including: a conductor pattern that has a shape corresponding to one end surface of a columnar spacer and that is formed on a circuit board; and a resist formed around the conductor pattern on the circuit board, the spacer being mounted on the circuit board in a posture in which the one end surface of the spacer is in contact with the conductor pattern, and the spacer having the other end surface to which an object to be fastened can be fastened, the spacer including a reduced portion formed around the one end surface, the reduced portion being formed by reducing an outer shape of the spacer so that a fillet of molten solder is formed between the conductor pattern exposed around the reduced portion and an outer circumferential surface of the reduced portion when the spacer is mounted on the circuit board.

According to the spacer for a circuit board configured in this manner, when the spacer is mounted on the conductor pattern, the conductor pattern is exposed in an annular shape around the reduced portion, the molten solder sticks to the outer circumferential surface of the reduced portion on the conductor pattern due to surface tension, and solidifies, thereby a fillet is formed. As a result, the spacer has the lower end surface joined to the conductor pattern via the planar solder layer, as well as having the entire circumference of the reduced portion restrained on the conductor pattern via the fillet. Although the fillet is annular and surrounds the circumference of the spacer, the fillet fits into the reduced portion, and will not be a cause of increasing the area occupied by the spacer on the circuit board.

Another aspect may be configured such that a cylindrical fitting portion is formed on the one end surface of the spacer, the cylindrical fitting portion fitting with an outer circumference of a circular resist formed so as to protrude in a step manner in a center of the conductor pattern on the circuit board.

With this configuration, when the spacer is mounted on the conductor pattern, the cylindrical fitting portion of the spacer is fitted to the circular resist on the circuit board, thereby positioning the spacer at the desired position.

Still another aspect may be configured such that: the spacer has a female screw for fastening the object to be fastened, the female screw being provided so as to penetrate the spacer from the one end surface to the other end surface; and the cylindrical fitting portion is formed in an opening portion of the female screw.

With this configuration, the cylindrical fitting portion can be formed by only slightly changing the shape of the opening portion of the female screw.

Still another aspect may be configured such that: the spacer has the reduced portion formed around the other end surface in addition to the one end surface; and the spacer has a shape symmetrical in its axial direction.

With this configuration, the reduced portion will exhibit the desired function, whether the spacer is mounted on the circuit board in a posture in which the one end surface is in contact with the conductor pattern or in a posture in which the other end surface is in contact with the conductor pattern.

Still another aspect may be configured such that: the spacer has the cylindrical fitting portion formed on the other end surface in addition to the one end surface; and the spacer has a shape symmetrical in its axial direction.

With this configuration, the cylindrical fitting portion will exhibit the desired function, whether the spacer is mounted on the circuit board in a posture in which the one end surface is in contact with the conductor pattern or in a posture in which the other end surface is in contact with the conductor pattern.

In still another aspect, the spacer may be made of aluminum.

This configuration makes it possible to overcome the disadvantage of the joining strength of the spacer made of aluminum, and to make the spacer lighter.

In still another aspect, the spacer may be made of a conductive material.

This configuration makes it possible to electrically connect the conductor pattern on the circuit board and the object to be fastened, through the spacer.

### Advantageous Effects of the Invention

According to the present invention, the spacer for a circuit board can be mounted on the circuit board with high joining strength while preventing increase in the area occupied by the spacer on the circuit board.

### Brief Description of the Drawings

FIG. 1 is a perspective view showing a case in which another circuit board is fastened onto a circuit board using a spacer of an embodiment.
FIG. 2 is an exploded perspective view corresponding to FIG. 1.
FIG. 3 is a perspective view showing a case in which a bus bar is fastened onto a circuit board using the spacer of the embodiment.
FIG. 4 is a perspective view showing a case in which a round terminal is fastened onto a circuit board using the spacer of the embodiment.
FIG. 5 is a cross-sectional view showing the spacer.
FIG. 6 is an enlarged cross-sectional view showing a soldering portion of the spacer corresponding to a detail of part A in FIG. 5, in comparison with prior arts 1 and 2.

### Mode for Carrying out the Invention

The following describes an embodiment of a spacer for a circuit board embodying the present invention.

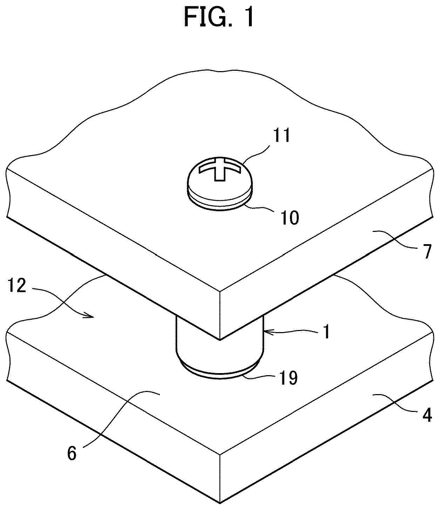

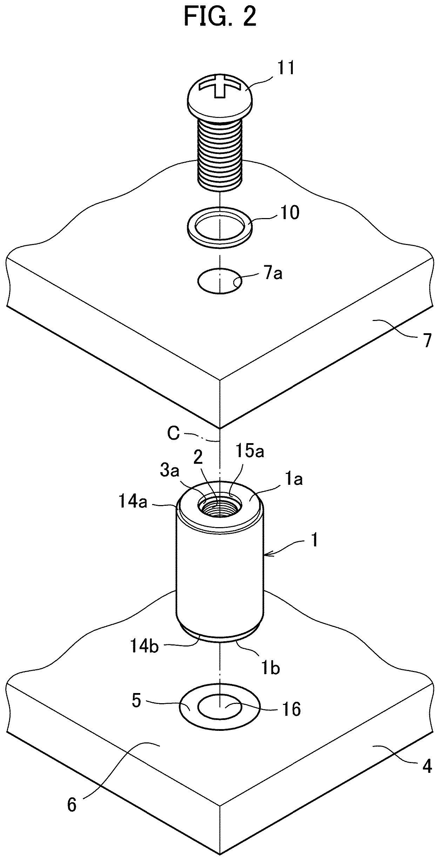

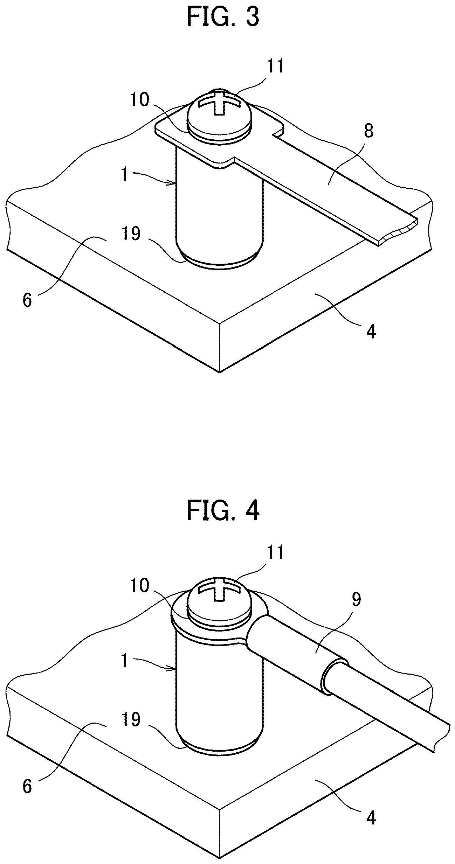

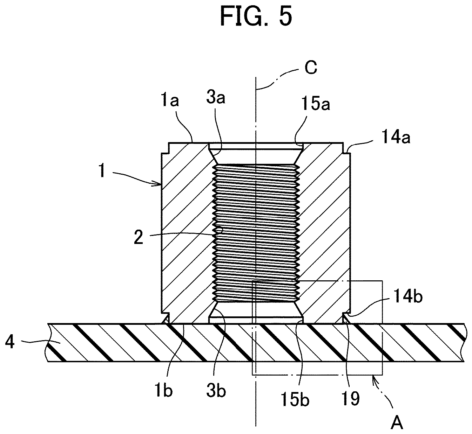

FIG. 1 is a perspective view showing a case in which another circuit board is fastened onto a circuit board using a spacer of the present embodiment, FIG. 2 is an exploded perspective view corresponding to FIG. 1, FIG. 3 is a perspective view showing a case in which a bus bar is fastened onto a circuit board using the spacer, FIG. 4 is a perspective view showing a case in which a round terminal is fastened onto a circuit board using the spacer, and FIG. 5 is a cross-sectional view showing the spacer. In the following description, the vertical direction is expressed following the posture of the spacer in FIG. 1.

First, a general configuration of the spacer will be described. As shown in FIGS. 2 and 5, the spacer 1 is cylindrical and extends in the vertical direction. The spacer 1 has a female screw 2 provided so as to penetrate the spacer 1 along an axis C of the spacer 1. On the upper end surface 1a (corresponding to "the other end surface" of the present invention) of the spacer 1, the upper part of the female screw 2 is open via a guide portion 3a expanding upward. Likewise, on the lower end surface 1b (corresponding to "one end surface" of the present invention) of the spacer 1, a lower part of the female screw 2 is open (corresponding to an "opening portion of the female screw" of the present invention) via a guide portion 3b expanding downward.

The spacer 1 of the present embodiment is made of a conductive metal material, such as aluminum. The manufacturing method to be applied to the spacer 1 can include any of the well-known techniques such as cutting, pressing, forming, and header processing. When aluminum is used for the material, a surface treatment such as tin plating is performed to prevent decrease in the joining strength of the solder due to an oxide film formed on the surface.

However, the material of the spacer 1 does not necessarily have to be a metal material. For example, since the lower part of the spacer 1 is mounted on the circuit board 4 as described later, the spacer 1 may be configured such that the lower part is made of metal and the other parts are insert-molded with synthetic resin material. Alternatively, the entire spacer 1 may be injection-molded with synthetic resin material and its surface may be metal-plated so that the spacer 1 is conductive and can be soldered.

The upper surface of the circuit board 4, on which such a spacer 1 is mounted, is formed with a circular conductor pattern 5 corresponding to the lower end surface 1b of the spacer 1. The conductor pattern 5 has a circumference on which a resist 6 is formed. For example, the conductor pattern 5 is formed by etching the copper foil attached to the circuit board 4 so as to leave the area of the conductor pattern 5. The resist 6 is formed by screen-printing a resist ink so as to leave the area of the conductor pattern 5 and then curing the ink by ultraviolet light irradiation. However, the manufacturing method is not limited to these, and other manufacturing methods may be applied.

The spacer 1 is mounted on the circuit board 4 together with electronic components (not shown), for example, by reflow soldering. The spacer 1 is mounted in such a manner that: solder paste is printed on the area of the conductor pattern 5; the spacer 1 is placed thereon by a chip mounter; and the solder paste and the spacer 1 then undergo a heating process in a furnace. However, the manner of the mounting work is not limited to this, and may be performed by, for example, reflow soldering.

The spacer 1 mounted on the circuit board 4 plays a role in fastening objects to be fastened onto the circuit board 4 at a predetermined interval. The objects to be fastened include another circuit board 7 shown in FIGS. 1 and 2, a bus bar 8 shown in FIG. 3, and a round terminal 9 shown in FIG. 4.

When another circuit board 7 is fixed above the circuit board 4, the spacer 1 is mounted, for example, on each of the four corners (only one corner is shown here) of the circuit board 4, as shown in FIGS. 1 and 2. As shown in FIG. 1, another circuit board 7 is disposed above the circuit board 4 and is brought into contact with the upper end surface 1a of the spacer 1, and a screw 11 is screwed into the female screw 2 of the spacer 1 through a screw hole 7a and a washer 10, the screw hole 7a being provided so as to penetrate each of the four corners of the other circuit board 7.

As a result, the other circuit board 7 is fastened to the circuit board 4 with a gap 12 equivalent to the length of the spacer 1, and this gap 12 prevents interference between the electronic components mounted on the circuit board 4 and the other circuit board 7. In addition, since the spacer 1 is conductive, it is possible to electrically connect the conductor pattern 5 on the circuit board 4 and the conductor pattern of the other circuit board 7 through the spacer 1, if necessary.

As shown in FIGS. 3 and 4, when a bus bar 8 or a round terminal 9 extending from another circuit board 7 is connected to the circuit board 4, the bus bar 8 or the round terminal 9 may be spaced upward from the circuit board 4 to prevent interference with electronic components on the circuit board 4. In such a case, the spacer 1 having a length equivalent to the distance between the two is mounted on the circuit board 4, and the bus bar 8 or the round terminal 9 is fastened to the upper end surface 1a of the spacer 1 by a screw 11 via a washer 10. In this case, the conductor pattern 5 is electrically connected to any of the electronic components on the circuit board 4, and the electronic component is electrically connected to another circuit board 7 through the spacer 1, and the bus bar 8 or the round terminal 9.

Note that the fastening structure of another circuit board 7, or the bus bar 8 or the round terminal 9 is not limited to the above. For example, a through hole may be formed in the spacer 1 instead of the female screw 2, and the screw 11 may be screwed into a nut, provided on the lower surface of the circuit board 4, via the through hole.

The spacer 1 is mounted on the circuit board 4 as described above. In contrast, in the prior art 1 described based on FIG. 6, the spacer 101 is only joined to the conductor pattern 105 via a planar solder layer 118 formed on the lower end surface 101b. This disadvantageously lowers the joining strength to the circuit board 4. In the prior art 2, the joining strength is increased by forming a fillet 119 around the spacer 101. However, the area occupied by the spacer 101 on the circuit board 4 disadvantageously increases by an amount corresponding to the area of the fillet 119 in a plan view.

In the present invention to solve these problems, a diameter-reduced portion (corresponding to a "reduced portion" of the present invention) is formed around the lower end surface 1b of the cylindrical spacer 1, the diameter-reduced portion being a portion having a reduced outer diameter (corresponding to an "outer shape" of the present invention). This secures the space for forming the fillet 19 described later without increasing the area occupied by the spacer 1 on the circuit board 4, and the details of this will be described below.

FIG. 6 is an enlarged cross-sectional view of the soldering portion of the spacer 1 corresponding to the detail of part A in FIG. 5, in comparison with the prior arts 1 and 2. As shown in FIGS. 2 and 5, the spacer 1 of the present embodiment has a shape vertically symmetrical (corresponding to "symmetrical in an axial direction" of the present invention). The purpose of this is to prevent erroneous mounting in mounting the spacer 1 on the circuit board 4. This exhibits the desired function in the mounting work, whether the spacer 1 is placed on the circuit board 4 in an upright posture or in the inverse posture, making it possible to obtain an effect in which the mounting work can be easily performed.

The following describes a diameter-reduced portion 14b and a cylindrical fitting portion 15b formed on the lower end surface 1b side based on FIGS. 5 and 6. The diameter-reduced portion 14a and the cylindrical fitting portion 15b on the upper end surface 1a side have the same shape and are vertically symmetrical, so a duplicated description will be omitted. A diameter-reduced portion 14b with an outer diameter reduced in a step manner is formed around the entire circumference of the lower end surface 1b of the spacer 1. The vertical dimension L1 and radial dimension L2 of the step made by the diameter-reduced portion 14b are each set to a size that does not prevent the formation of the fillet 19 by the molten solder. For example, each of them is set to 0.3 mm or more. However, each of them may be less than 0.3 mm depending on the position and purpose of use, and the case in which the diameter-reduced portion 14b is set in this manner is also included in the present invention.

In addition, the guide portion 3b expands downward onto the lower end surface 1b of the spacer 1. The lower part of the guide portion 3b is formed in a cylindrical shape having a constant inner diameter in the vertical direction, and this part corresponds to the cylindrical fitting portion 15b.

As described above, on the circuit board 4, the resist 6 is formed around the circular conductor pattern 5. In the present embodiment, the outer diameter of the conductor pattern 5 is set to substantially the same dimension as the outer diameter of the spacer 1, as shown in FIG. 6. In addition, a circular resist 16 centered on the axis C is also formed in the center of the conductor pattern 5, and as a result, the conductor pattern 5 is annular. Hereinafter, this portion will be referred to as the circular resist 16. The outer diameter of the circular resist 16 is set to be equal to or slightly smaller than the inner diameter of the cylindrical fitting portion 15b of the spacer 1.

As shown in FIG. 6, the thickness T2 of the resist 6 on the outer circumference side and the circular resist 16 on the inner circumference side is set to be larger than the thickness T1 of the conductor pattern 5 on the circuit board 4. More specifically, the thickness T2 of the resists 6 and 16 is set to be larger than the thickness T1 of the conductor pattern 5 plus the thickness T3 of the solder paste 17. Even if the solder paste 17 melts, its thickness T3 only changes in the decreasing direction due to evaporation of the flux and the formation of the fillet 19. For this reason, the relationship T2 > T1 + T3 is kept until the molten solder solidifies as the solder layer 18 to determine the position of the spacer 1 on the conductor pattern 5.

Therefore, the circular resist 16 protrudes upward in a step manner from the center of the surrounding conductor pattern 5 (more specifically, the solder paste 17 on the conductor pattern 5). Note that since it is the thickness T2 of the circular resist 16 that needs to keep this size relationship, the thickness of the resist 6 may be set to a thickness other than T2.

With the above-mentioned inter-dimension setting, when the spacer 1 is placed on the conductor pattern 5, on which the solder paste 17 is printed, in the mounting work of the spacer 1, the cylindrical fitting portion 15b of the spacer 1 is fitted to the circular resist 16 protruding from the center of the conductor pattern 5. As a result, the spacer 1 is positioned at the desired position where the axis C is aligned with the circular resist 16. This causes the outer circumferential surface of the spacer 1 to coincide with the inner circumference of the resist 6, and causes the solder paste 17 to be exposed in an annular shape around the diameter-reduced portion 14b of the spacer 1.

Even if the solder paste 17 melts in the heating process in the furnace, the spacer 1 is kept being positioned by the fitting between the circular resist 16 and the cylindrical fitting portion 15b. The molten solder exposed around the spacer 1 then sticks to the outer circumferential surface of the diameter-reduced portion 14b of the spacer 1 (corresponding to an "outer circumferential surface" of the present invention) due to surface tension, and solidifies, thereby forming a fillet 19 with a substantially triangular cross section within the diameter-reduced portion 14b. As a result, the spacer 1 has the lower end surface 1b joined to the conductor pattern 5 via the planar solder layer 18, as well as having the entire circumference of the diameter-reduced portion 14b restrained on the conductor pattern 5 via the fillet 19, as in the prior art 2 of FIG. 6. For this reason, the spacer 1 can be mounted on the circuit board 4 with a higher joining strength than in the prior art 1.

Although the fillet 19 is annular and surrounds the circumference of the spacer 1, it fits to the diameter-reduced portion 14b without protruding from the outer diameter of the spacer 1. As a result, as shown in FIG. 6 as "equivalent to occupied area," the formation of the fillet 19 will not be a cause of increasing the area occupied by the spacer 1 on the circuit board 4. Therefore, the spacer 1 can be mounted on the circuit board 4 with an occupied area equivalent to that of the prior art 1, or in other words, the area occupied on the circuit board 4 can be reduced compared to the prior art 2 of FIG. 6.

The spacer 1 of the present embodiment has a vertically symmetrical shape. As a result, the same actions and effects as above can be achieved even if the spacer 1 is mounted on the circuit board 4 in a posture that is upside down compared to FIG. 6.

On the other hand, in the present embodiment, the spacer 1 is positioned by the fitting between the circular resist 16 and the cylindrical fitting portion 15b, thereby improving the accuracy of the mounting position of the spacer 1. This point will be explained based on a comparison with the prior arts 1 and 2.

First, in the prior art 1 shown in FIG. 6, the thickness of the resist 106 is set to be larger than the thickness of the conductor pattern 105 plus the solder paste 117 on the circuit board 104. This causes the lower end portion of the spacer 101 placed on the conductor pattern 105 to be fitted to the inner circumference of the resist 106, and provides an action for positioning to the desired position.

In contrast, in the prior art 2, the conductor pattern 5 is expanded toward the outer circumference and exposed upward to form the fillet 19. This causes the inner circumference of the resist 106 to be separated toward its outer circumference with respect to the outer circumference of the spacer 101, and does not provide any action for positioning. As a result, when the solder paste 17 melts, the spacer 101 floats on the molten solder and cannot be kept at the desired position. Note that the surface tension of the molten solder causes a so-called self-centering phenomenon that guides the spacer 101 to the center on the conductor pattern 105, but the action is so small that accurate positioning cannot be expected.

As a countermeasure, in the present embodiment, a circular resist 16 is formed on the inner circumference side of the conductor pattern 5. As is clear from the prior arts 1 and 2 in FIG. 6, since the inner circumference side of the conductor pattern 5 is an area corresponding to a dead space that is not used at all, the circular resist 16 can be formed without affecting the surrounding region. Then, a cylindrical fitting portion 15b is formed on the spacer 1 side corresponding to this circular resist 16, and is fitted to the circular resist 16 protruding from the center of the conductor pattern 5, thereby obtaining an action for positioning.

Therefore, as in the prior art 1, the spacer 1 can be reliably mounted at the desired position on the circuit board 4. This finally provides a great contribution to improving the positional accuracy of the object to be fastened onto the spacer 1, such as another circuit board 7, the bus bar 8, or the round terminal.

Furthermore, in the present embodiment, the female screw 2 is provided so as to penetrate the spacer 1 from the upper end surface 1a to the lower end surface 1b, and has opening portions that are the guide portions 3a and 3b formed with cylindrical fitting portions 15a and 15b. For example, the action for positioning can be obtained by the female screw 2 that does not penetrate the spacer 1 but is provided only on the upper end surface 1a side, and by the cylindrical fitting portion 15b that is a recess provided on the lower end surface 1b of the spacer 1. Such aspect is also included in the present invention, but this involves trouble to form the cylindrical fitting portion 15b. When the female screw 2 is penetrated, the cylindrical fitting portions 15a, 15b can be formed by only slightly changing the shape of the guide portions 3a, 3b that are the opening portions of the female screw 2. This brings another advantage that simplifies the manufacture of the spacer 1.

On the other hand, the spacer 1 of the present embodiment is made of aluminum, and the spacers 101 of the prior arts 1 and 2 are made of brass, and the specific gravity of aluminum is approximately 2.7 and the specific gravity of brass is approximately 8.5. Although there are slight differences in shape between the two spacers 1 and 101, such as the presence or absence of the diameter-reduced portion 14b and the cylindrical fitting portion 15b, they have approximately the same volume. Therefore, the weight ratio between them should correspond to the specific gravity ratio between them. As a result, the spacer 1 of the present embodiment can be significantly lighter than the spacer 101 of the prior arts 1 and 2.

In addition, as is well-known, since aluminum has an electrical conductivity and an electrical resistance close to those of brass, the rated current value and the rate of temperature rise when the aluminum spacer 1 is used as a conductor can bear comparison with the brass spacer 101 of the prior arts 1 and 2.

Although the aluminum spacer 1 has such advantages, it has a disadvantage that decreases the solder joining strength due to the oxide film. In consideration of this point, a surface treatment such as tin plating is performed in the present embodiment, but in some cases, the surface treatment may be skipped from the viewpoint of manufacturing costs, etc.

In this case, the oxide film may cause the joining strength to the circuit board 4 to be insufficient, but in the present embodiment, the formation of the fillet 19 allows sufficient joining strength to be kept. As a result, the present embodiment makes it possible to compensate for the disadvantage of the joining strength when the spacer 1 is made of aluminum, and to provide a new advantage of weight reduction.

The above explanation does not intend to limit the present invention to the spacer 1 made of aluminum, and of course, brass spacers and the like are also included in the present invention.

The formation of the fillet 19 is also useful in the following respect. After mounting of the spacer 1 on the circuit board 4, the quality of the soldering is visually inspected. In the present embodiment, when the spacer 1 is properly soldered, a fillet 19 of the desired shape is formed around the spacer 1, so that the quality of the soldering can be determined based on the presence or absence and shape of the fillet 19. This is also the case with the prior art 2, but the prior art 1, which is not formed with the fillet 19 from the beginning, has difficulty in the quality determination. Therefore, the present embodiment can also provide an advantage that the spacer 1 can be easily inspected after mounting.

This concludes the explanation of the embodiment, but the aspects of the present invention are not limited to the present embodiment. For example, in the above embodiment, the cylindrical fitting portions 15a, 15b are formed in addition to the diameter-reduced portions 14a, 14b on the spacer 1, but for example, the cylindrical fitting portions 15a, 15b may be omitted.

In the above embodiment, the spacer 1 is cylindrical and has a vertically symmetrical shape to prevent erroneous mounting, but the shape is not limited to this. For example, the spacer 1 may have a quadrangular prism shape or the like. In addition, the diameter-reduced portion 14a and the cylindrical fitting portion 15a on the upper end surface 1a side may be omitted. This increases the contact area with the bus bar 8 or the round terminal 9 in exchange for preventing erroneous mounting, making it possible to more reliably prevent poor contact.

### Explanation of Reference Signs

- 1: spacer
- 1a: upper end surface (other end surface)

- 1b: lower end surface (one end surface)
- 2: female screw
- 3a, 3b: guide portion (opening portion)
- 4: circuit board
- 5: conductor pattern
- 6: resist
- 7: another circuit board (object to be fastened)
- 8: bus bar (object to be fastened)
- 9: round terminal (object to be fastened)
- 14a, 14b: diameter-reduced portion (reduced portion)
- 15a, 15b: cylindrical fitting portion
- 16: circular resist
- 19: fillet

## Claims

1. A spacer for a circuit board to be applied to a mounting structure of a circuit board, the mounting structure including: a conductor pattern that has a shape corresponding to one end surface of a columnar spacer and that is formed on a circuit board; and a resist formed around the conductor pattern on the circuit board, the spacer being mounted on the circuit board in a posture in which the one end surface is in contact with the conductor pattern, and the spacer having the other end surface to which an object to be fastened can be fastened,the spacer comprising a reduced portion formed around the one end surface, the reduced portion being formed by reducing an outer shape of the spacer so that a fillet of molten solder is formed between the conductor pattern exposed around the reduced portion and an outer circumferential surface of the reduced portion when the spacer is mounted on the circuit board.

2. The spacer for a circuit board according to claim 1,wherein a cylindrical fitting portion is formed on the one end surface of the spacer, the cylindrical fitting portion fitting with an outer circumference of a circular resist formed so as to protrude in a step manner in a center of the conductor pattern on the circuit board.

3. The spacer for a circuit board according to claim 2, wherein the spacer has a female screw for fastening the object to be fastened, the female screw being provided so as to penetrate the spacer from the one end surface to the other end surface, and the cylindrical fitting portion is formed in an opening portion of the female screw.

4. The spacer for a circuit board according to claim 1, wherein the spacer has the reduced portion formed around the other end surface in addition to the one end surface, and the spacer has a shape symmetrical in its axial direction.

5. The spacer for a circuit board according to claim 2, wherein the spacer has the cylindrical fitting portion formed on the other end surface in addition to the one end surface, and the spacer has a shape symmetrical in its axial direction.

6. The spacer for a circuit board according to any one of claims 1 to 5, wherein the spacer is made of aluminum.

7. The spacer for a circuit board according to any one of claims 1 to 5,
wherein the spacer is made of a conductive material.
